# EUROPÄISCHE PATENTSCHRIFT

(11) **EP 0 438 620 B1**
(45) Veröffentlichungstag und Bekanntmachung des Hinweises auf die Patenterteilung: **02.10.1996**
(21) Anmeldenummer: 90101407.6
(22) Anmeldetag: 24.01.1990
(51) Int. Cl.: H03L 7/093

(54) **Verfahren und Schaltungsanordnung zur Minimierung eines Wechselanteils eines Phasendetektorausgangssignals eines Phasenregelkreises**
Method and circuit arrangement for the minimization of an a.c. component in the phase detector output signal of a phase locked loop
Méthode et montage de circuit pour la minimalisation d'une variation dans le signal d'un détecteur de phase d'une boucle à verrouillage de phase

(43) Veröffentlichungstag der Anmeldung: 31.07.1991
(73) Patentinhaber: SIEMENS AKTIENGESELLSCHAFT, 80333 München (DE)
(72) Erfinder: Tiedtke, Jürgen, Dipl.-Ing., D-8521 Grossenseebach (DE)

(56) Entgegenhaltungen:
- GB-A- 1 447 418
- GB-A- 2 184 617
- PATENT ABSTRACTS OF JAPAN, Band 6, Nr. 55 (E-101)[933], 10. April 1982; & JP-A-56 169 927
- IDEM

## Beschreibung

Die Erfindung bezieht sich auf ein Verfahren und auf eine Schaltungsanordnung zur Minimierung eines Wechselanteils eines Phasendetektorausgangssignals eines Phasenregelkreises, der aus einem Phasendetektor, einem Regler und einem gesteuerten Oszillator besteht.

Ein derartiger Phasenregelkreis ist aus "Halbleiter-Schaltungstechnik", U.Tietze und Ch. Schenk, 6. Auflage, 1983, Seiten 817 bis 829, bekannt. In der Nachrichtentechnik wird ein derartiger Regelkreis auch Nachlaufsynchronisation genannt. Phasenregelkreise (Phase-Locked-Loop, PLL) haben die Aufgabe, die Frequenz eines Oszillators so einzustellen, daß sie mit der Frequenz eines Bezugsoszillators übereinstimmt, und zwar so genau, daß die Phasenverschiebung nicht wegläuft. Wenn der Phasenregelkreis als Frequenzvervielfacher eingesetzt wird, braucht lediglich je ein Frequenzteiler vor die Eingänge des Phasendetektors geschaltet zu werden. Bei verschiedenen Phasenregelkreisen unterscheiden sich nur die Ausführungsformen des Phasendetektors und des Reglers. Der in GB-A-2 184 617 dargestellte Frequenz synthesizer besteht aus einem Phasen-und frequenz-detektor mit nachgeschaltetem spannungsgestewerten Oszillator, einer Schaltung zur Pulsauslöschung mit nachgeschaltetem Teiler und einer Multiplikationsschaltung. Die Schaltung zur Pulsauslöschung ist eingangsseitig mit dem Ausgang des Oszillators verknüpft, wobei der Ausgang des Teilers einerseits mit einem zweiten Eingang des Detektors und anderseits mit der Multiplikationsschaltung verbunden ist.

Der Ausgang der Multiplikationsschattung ist mit einem weiteren Eingang mit der Schaltung zur Pulsauslöschung verbunden. Eine Korrektursignalschaltung und ein analoger Addierer Kompensiert die Phasensynchronisationsstörung, die bei jeder Pulsauslöschung verursacht wird.

Bisherige Entwicklungen von Phasenregelkreisen bilden einen Kompromiß aus schnellem Ansprechverhalten und annehmbarer Glättung des Eingangssignals des Oszillators. Dieser Kompromiß entsteht dadurch, daß beim Ausgangssignal des Phasendetektors lediglich dessen zeitlicher Mittelwert die Information über die Phasendifferenz beider verglichenen Signale enthält, dem aber funktionsbedingt ein vom Typ des Phasendetektors und von der Signalform beider Eingangssignale abhängiger Wechselanteil als Störung überlagert ist. Wünscht man nun einen gleichmäßigen Verlauf des Ausgangssignals des Oszillators, so muß das Eingangssignal des Oszillators im stationären Zustand konstant sein.

Folglich muß der Regler (Schleifenfilter) so dimensioniert werden, daß das Ausgangssignal des Phasendetektors entsprechend stark geglättet wird. Dadurch wird aber ein schnelles Ansprechen und Folgen des Regelkreises auf Phasenänderungen des Eingangssignals unmöglich.

Der Erfindung liegt nun die Aufgabe zugrunde, ein Verfahren und eine Schaltungsanordnung zur Minimierung eines Wechselanteils eines Phasendetektorsignals eines Phasenregelkreises anzugeben, wobei sich das Ansprechverhalten des Phasenregelkreises nicht verschlechtern soll.

Diese Aufgabe wird erfindungsgemäß dadurch gelöst, daß mittels eines Oszillatorausgangssignals ein Phasendetektorausgangssignal des eingerasteten Phasenregelkreises als Korrektursignal nachgebildet wird, das in Phasenlage und Frequenz fest auf die Grundschwingung des eingerasteten Phasenregelkreises bezogen ist und das fortlaufend vom Phasendetektorausgangssignal subtrahiert wird.

Bei einem bekannten Phasenregelkreis mit bekannter Eingangssignalform kennt man auch das Phasendetektorausgangssignal im stationären bzw. eingerasteten Zustand des Phasenregelkreises. Das Phasendetektorausgangssignal besteht aus einem Gleichanteil, der die Information über die Phasendifferenz enthält, und einem Wechselanteil, der von der Art des Phasendetektors und dem Spektrum der zu vergleichenden Signale abhängt. Dieser beispielsweise aus Sinusstücken bestehende Wechselanteil wird in Form eines Korrektursignals nachgebildet, das in Phasenlage und Frequenz fest auf die Grunschwingung des eingerasteten Phasenregelkreises bezogen ist. Dieses Korrektursignal wird dann fortlaufend vom Phasendetektorausgangssignal subtrahiert, wodurch der Wechselanteil dieses Phasendetektorausgangssignals minimiert wird. Dadurch wird das Oszillatoreingangssignal gut geglättet, ohne das Ansprechverhalten zu verändern.

Mit diesem Verfahren können vorhandene Phasenregelkreise bei gleicher Glättung wesentlich dynamischer ausgelegt werden bzw. weisen bei unverändertem Regler eine wesentlich bessere Glättung des Oszillatoreingangssignals auf. Somit ist durch dieses Verfahren die gegensätzliche Kopplung zwischen schnellem Ansprechverhalten und guter Glättung aufgebrochen worden, wodurch das Ansprechverhalten und die Glättung unabhängig voneinander einstellbar sind.

Außerdem wird diese Aufgabe erfindungsgemäß dadurch gelöst, daß mittels eines Oszillatorausgangssignale ein Eingangssignal des eingerasteten Phasenregelkreises als Korrektursignal nachgebildet wird, das in Phasenlage und Frequenz fest auf die Grundschwingung des eingerasteten Phasenregelkreises bezogen ist und das fortlaufend vom Eingangssignal subtrahiert wird. Dieses Verfahren unterscheidet sich vom vorgenannten Verfahren dadurch, daß die Erzeugung eines Korrektursignals sich auf den Eingang des Phasendetektors bezieht. D.h., mittels des erzeugten Korrektursignals im stationären bzw. eingerasteten Zustand des Phasenregelkreises das Eingangssignal des Phasendetektors verschwindet. Bei diesem Verfahren ist die Bildung des Korrektursignals besonders einfach, da überwiegend als Eingangssignal eine Sinusschwingung oder eine Rechteckschwingung verwendet wird.

Bei einer erfindungsgemäßen Schaltungsanordnung zur Durchführung des Verfahrens mit einem Phasenregelkreis, bestehend aus einer Reihenschaltung eines Phasendetektors, eines Reglers und eines auf den Phasendetektor rückgekoppelten, gesteuerten Oszillators, ist dem Phasendetektor ein Vergleicher nachgeschaltet, der ausgangsseitig mit dem Regler verknüpft ist, und ist ein Korrektursignalbildner eingangsseitig mit dem Ausgang des gesteuerten Oszillators und ausgangsseitig mit dem negativen Eingang des Vergleichers verbunden. Durch diese Ausgestaltung erhält der bekannte Phasenregelkreis eine zweite Rückführung, wodurch das Ansprechverhalten des Regelkrei ses und die Glättung des Oszillatoreingangssignals unabhängig voneinander einstellbar sind.

Bei einer anderen erfindungsgemäßen Schaltungsanordnung zur Durchführung des erfindungsgemäßen Verfahrens mit einem Phasenregelkreis, bestehend aus einer Reihenschaltung eines Phasendetektors, eines Reglers und eines auf den Phasendetektor rückgekoppelten, gesteuerten Oszillators, ist dem Phasendetektor ein Vergleicher vorgeschaltet, an dessen positivem Eingang ein Eingangssignal ansteht, und ist ein Korrektursignalbildner eingangsseitig mit dem Ausgang des gesteuerten Oszillators und ausgangsseitig mit dem negativen Eingang des Vergleichers verbunden. Durch diese Ausgestaltung wird erreicht, daß im stationären bzw. eingerasteten Zustand des Phasenregelkreises das Eingangssignal des Phasendetektors beispielsweise verschwinden kann, wodurch innerhalb des Fangbereichs des Phasenregelkreises der Wechselanteil des Phasendetektorausgangssignals minimiert wird.

Bei einer vorteilhaften Schaltungsanordnung ist dem Korrektursignalbildner ein Gleichanteilfilter nachgeschaltet. Durch die Korrekturrückführung als weitere Rückkopplung des Phasenregelkreises kann u.U. durch einen auftretenden Gleichanteil diese Rückkopplung bereichsweise zur Mitkopplung werden, wodurch ein instabiles Verhalten des Phasenregelkreises entsteht. Durch das Gleichanteilfilter wird der zeitliche Mittelwert des Korrektursignals Null, so daß der Phasenregelkreis immer ein stabiles Regelverhalten aufweist.

Vorteilhafte Ausführungsformen des Korrektursignalbildners sind den Unteransprüchen 9 und 10 und eine vorteilhafte Ausführungsform des Gleichanteilfilters ist dem Unteranspruch 12 zu entnehmen.

Zur weiteren Erläuterung der Erfindung wird auf die Zeichnung Bezug genommen, in der jeweils ein Ausführungsbeispiel zur Durchführung eines erfindungsgemäßen Verfahrens schematisch veranschaulicht ist.
- Figur 1: zeigt eine vorteilhafte Schaltungsanordnung zur Durchführung eines ersten erfinderischen Verfahrens, in
- Figur 2: ist eine vorteilhafte Schaltungsanordnung zur Durchführung eines zweiten erfinderischen Verfahrens dargestellt, in
- Figur 3: sind in einem Diagramm über der Zeit t ein Eingangssignal u₁ und ein Ausgangssignal u₄ des Phasenregelkreises nach Figur 1 oder 2 ohne Aufschaltung des Korrektursignals dargestellt, in
- Figur 4: sind in einem Diagramm über der Zeit t ein Phasendetektorausgangssignal u_{PD} und ein Oszillatoreingangssignal u_{CO} eines Phasenregelkreises nach Figur 1 oder 2 ohne Aufschaltung des Korrektursignals veranschaulicht, in
- Figur 5: sind in einem Diagramm über der Zeit t ein Eingangssignal u₁ und ein Korrektursignal u_{korr'} des Phasenregelkreises nach Figur 2 dargestellt und in
- Figur 6: sind in einem Diagramm über der Zeit t ein Phasendetektorausgangssignal u_{PD} und ein Oszillatoreingangssignal u_{CO} eines Phasenregelkreises nach Figur 2 mit Aufschaltung des erzeugten Korrektursignals u_{korr'} veranschaulicht.

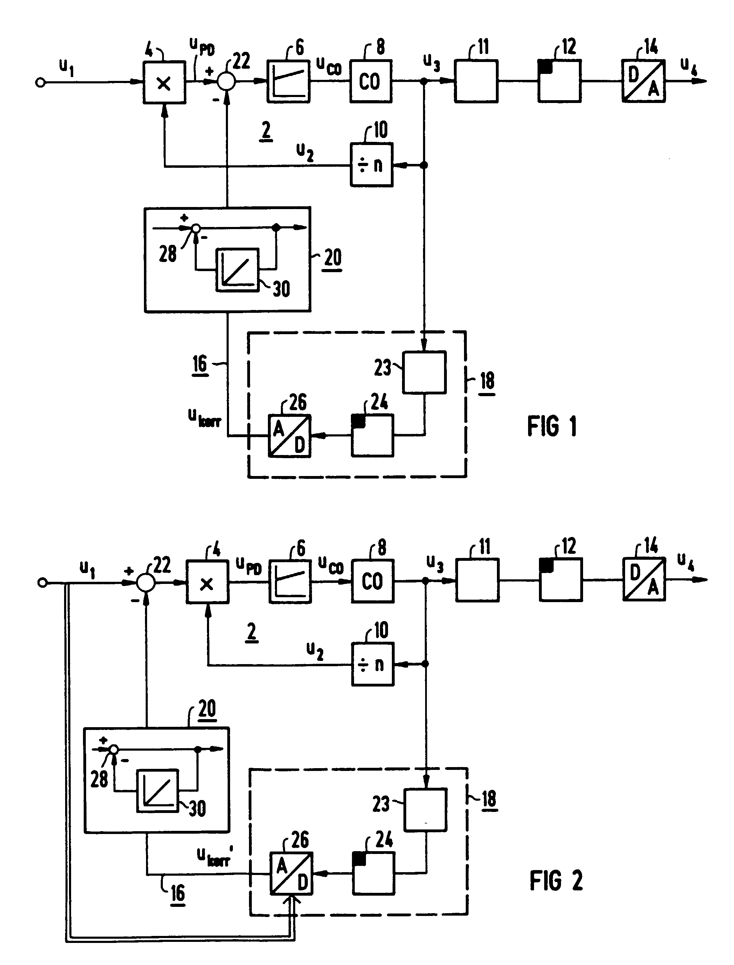

Die Figur 1 zeigt einen Phasenregelkreis 2, der aus einem Phasendetektor 4, einem Regler 6 und einem gesteuerten Oszillator 8 (Controlled Oscillator, CO) und einem Teiler 10 besteht. In der Literatur wird der Regler 6 auch als Schleifenfilter bezeichnet. Dem Phasendetektor 4 ist ein Eingangssignal u₁ mit der Frequenz f₁, die im gewählten Beispiel der Netzfrequenz von 50 Hz entspricht, zugeführt. Als Phasendetektor 4 ist beispielsweise ein phasensynchroner Gleichrichter vorgesehen, der das Eingangssignal u₁ mit einem Rechtecksignal u₂ mit der Grundfrequenz auf die der Phasenregelkreis 2 eingerastet ist, multipliziert. Dieses Rechtecksignal u₂ steht am Ausgang des Teilers 10 an, dessen Eingang ausgangsseitig mit dem gesteuerten Oszillator 8 verknüpft ist. Mittels des Teilers 10 wird das Oszillatorausgangssignal u₃ auf die Grundfrequenz des eingerasteten Phasenregelkreises 2 heruntergeteilt. Eingangsseitig ist der Oszillator 8 über den Regler 6 mit dem Ausgang des Phasendetektors 4 verbunden. Ausgangsseitig ist der Oszillator 8 über einen Zähler 11 mit nachgeschaltetem Speicher 12 mit einem Digital-Analog-Wandler 14 verknüpft, an dessen Ausgang ein Ausgangssignal u₄ des Phasenregelkreises 2 ansteht.

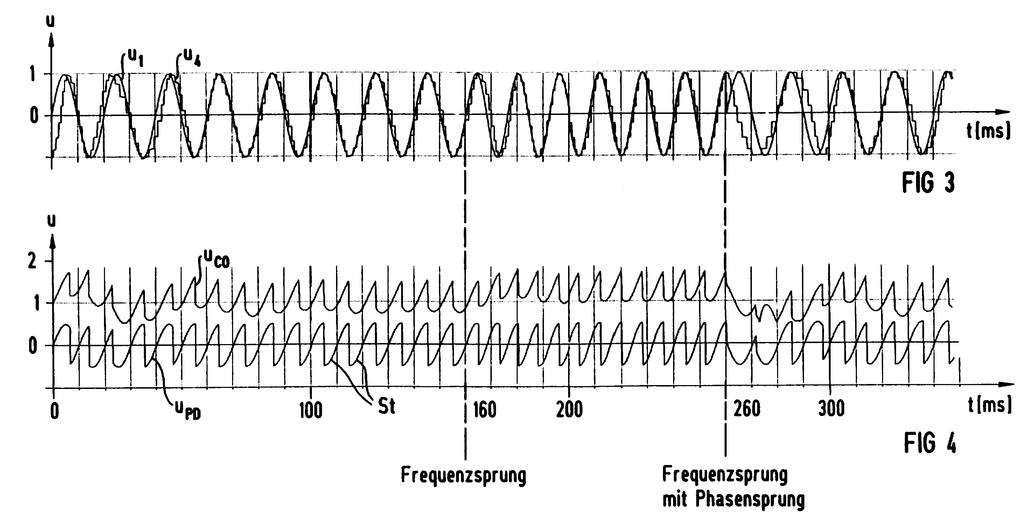

Die einzelnen Signalverläufe dieses Phasenregelkreises 2 sind in den Figuren 3 und 4 dargestellt. Dabei sind das Eingangssignal u₁ und das Ausgangssignal u₄ in einem Diagramm über der Zeit t dargestellt. Das Phasendetektorausgangssignal u_{PD} und das Oszillatoreingangssignal u_{CO} sind gemeinsam in einem Diagramm über der Zeit t veranschaulicht. Durch eine geringe Zeitauflösung, beispielsweise 4 Bit, erscheint das Ausgangssignal u₄ treppenförmig. Diese geringe Zeitauflösung wurde gewählt, damit im eingerasteten Zustand des Phasenregelkreises 2 die beiden Signale u₁ und u₄ in einem Diagramm erkennbar bleiben. Gemäß dem Diagramm nach Figur 4 schwankt das Phasendetektorausgangssignal u_{PD} um den Mittelwert "O" und das Oszillatoreingangssignal u_{CO} um den Mittelwert "1" entsprechend einer Frequenz f₁ = 50 Hz. Idealerweise würde im stationären Zustand ein glattes Oszillatoreingangssignal u_{CO} mit dem Mittelwert "1" zu erwarten sein. Da jedoch das Ansprechverhalten und die Glättung des Oszillatoreingangssignals u_{CO} sich gegensätzlich zueinander verhalten, ist die Abstimmung des Phasenregelkreises 2 immer ein Kompromiß. Dadurch, daß das Oszillatoreingangssignal u_{CO}, beding durch den Wechselanteil des Phasendetektorausgangssignals u_{PD}, einen Wechselanteil aufweist, bleibt selbst im eingerasteten Zustand durch die wellige Oszillatoreingangsinformation, die einen unregelmäßigen Oszillatorlauf verursacht, (t = 140 ms. - 160 ms. eine geringe Phasendifferenz zwischen dem Eingangssignal u₁ und dem Ausgangssignal u₄.

Zum Zeitpunkt t = 160 ms. ist die Frequenz f₁ von 50 Hz auf 62,5 Hz heraufgesetzt worden und zum Zeitpunkt t = 260 ms. wieder zurückgesetzt worden mit gleichzeitigem Phasensprung.

Gemäß Figur 1 ist der bekannte Phasenregelkreis 2 mit einer Korrekturrückführung 16 versehen. Diese Korrekturrückführung 16 besteht aus einem Korrektursignalbildner 18 mit einem nachgeschalteten Gleichanteilfilter 20, wobei das Gleichanteilfilter 20 nur dann verwendet werden muß, wenn durch Gleichanteile in der Korrekturrückführung 16 der Phasenregelkreis 2 bereichsweise ein instabiles Verhalten aufweist. Das Gleichanteilfilter 20 ist ausgangsseitig mit einem negativen Eingang eines Vergleichers 22 verknüpft, wobei der Vergleicher 22 mit seinem positiven Eingang mit dem Ausgang des Phasendetektors 4 verbunden ist. Ausgangsseitig ist der Vergleicher 22 mit dem Eingang des Reglers 6 verknüpft. Der Korrektursignalbildner 18 ist eingangsseitig mit dem Ausgang des gesteuerten Oszillators 8 verbunden.

Eine vorteilhafte Ausführungsform des Korrektursignalbildners 18 besteht darin, daß eingangsseitig ein Zähler 23 mit nachgeschaltetem Speicher 24 und ausgangsseitig ein Digital-Analog-Wandler 26 vorgesehen sind. Als Korrektursignalbildner 18 kann auch ein Funktionsgenerator vorgesehen sein, mit dem man eine beliebige Funktion in Abhängigkeit des Oszillatorausgangssignals u₃ erzeugen kann. Außerdem besteht die Möglichkeit, die Amplitude des Korrektursignals auf die Amplitude des Eingangssignals zu normieren.

Das Gleichanteilfilter 20 kann als Regelkreis aufgebaut sein, wobei ein Vergleicher 28 ausgangsseitig über einen integral wirkenden Regler 30 auf seinen negativen Eingang rückgekoppelt ist.

Gemäß dem Verfahren nach Anspruch 1 wird mittels des Korrektursignalbildners 18 ein dem Phasendetektorausgangssignal u_{PD} des eingerasteten Phasenregelkreises 2 entsprechendes Korrektursignal uₖₒᵣᵣ erzeugt, das dann vom Phasendetektorausgangssignal u_{PD} fortlaufend subtrahiert wird. Nach Figur 4 besteht das Phasendetektorausgangssignal u_{PD} im gewählten Beispiel aus einzelnen aneinandergesetzten Sinusstücken St. Diese Sinusstücke St können mittels einer im Speicher 24 des Korrektursignalbildners 18 abgelegten Signaltabelle und mittels des Digital-Analog-Wandlers 26 erzeugt werden. Durch die Subtraktion dieser Sinusstücke St, die in Phasenlage und Frequenz fest auf die Grundschwingung des eingerasteten Phasenregelkreises bezogen sind, wird der Wechselanteil des Phasendetektorausgangssignals u_{PD} und damit der Wechselanteil des Oszillatoreingangssignals u_{CO} minimiert. Durch die Verwendung eines multiplizierenden Digital-Analog-Wandlers als Digital-Analog-Wandler 26 kann die Amplitude des Korrektursignals uₖₒᵣᵣ in Abhängigkeit der Amplitudenänderung des Eingangssignals u₁ verändert werden.

In Figur 2 ist ebenfalls ein Phasenregelkreis 2 nach Figur 1 dargestellt, wobei funktionsgleiche Blöcke auch gleiche Bezugszeichen haben. Bei diesem Phasenregelkreis 2 ist der Vergleicher 22 dem Phasendetektor 4 vorgeschaltet. Dadurch wird das erzeugte Korrektursignal u_{korr'} vom Eingangssignal u₁ subtrahiert. Das Korrektursignal u_{korr'} entspricht in dieser Ausführungsform dem Eingangssignal u₁, wobei das Korrektursignal u_{korr'} in Phasenlage und Frequenz auf die Grundschwingung des eingerasteten Phasenregelkreises 2 bezogen ist. Durch die Verwendung eines multiplizierenden Digital-Analog-Wandlers als Digital-Analog-Wandler 26 kann die Amplitude des Korrektursignals uₖₒᵣᵣ in Abhängigkeit der Amplitudenänderung des Eingangssignals u₁ verändert werden. Durch die Verwendung eines multiplizierenden Digital-Analog-Wandlers als Digital-Analog-Wandler 26 kann die Amplitude des Korrektursignals u_{korr'} in Abhängigkeit der Amplitudenänderung des Eingangssignals u₁ verändert werden.

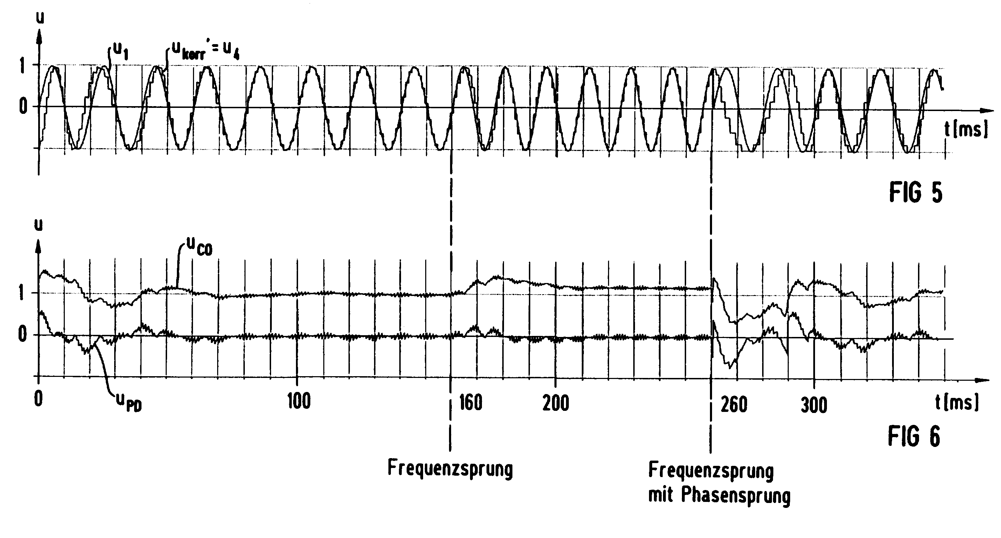

In der Figur 5 sind das Eingangssignal u₁, das Korektursignal u_{korr'} und das Ausgangssignal u₄ in einem Diagramm über der Zeit t dargestellt, wobei das Ausgangssignal u₄ dem Korrektursignal u_{korr'} gleicht. Das Phasendetektorausgangssignal u_{PD} und das Oszillatoreingangssignal u_{CO} sind in einem Diagramm über der Zeit t in der Figur 6 dargestellt. Die Treppenform des Korrektursignals u_{korr'} bzw. des Ausgangssignals u₄ entsteht durch eine geringe Zeitauflösung der Sinusfunktion. Diese geringe Zeitauflösung ist nur zum Zwecke einer verständlichen Darstellung gewählt worden.

Durch die Erzeugung dieses Korrektursignals u_{korr'} verschwindet im stationären Zustand des Phasenregelkreises 2 das Phasendetektorausgangssignal u_{PD}, und das Oszillatoreingangssignal u_{CO} wird "1" entsprechend der Frequenz f₁ des Eingangssignals u₁, nämlich 50 Hz. Außerdem bleibt zwischen dem Eingangssignal u₁ und dem Ausgangssignal u₄ keine noch so kleine Phasenverschiebung bestehen, wie in Figur 5 ersichtlich ist. Die Hochfrequenzschwingungen, die dem Phasendetektorausgangssignal u_{PD} und dem Oszillatoreingangssignal u_{CO} überlagert sind, stammen von der geringen Zeitauflösung des synthetisch erzeugten Korrektursignals u_{korr'} und beeinflussen das Regelverhalten praktisch nicht.

Somit besteht die Möglichkeit bei unverändertem Regler 6 eines bekannten Phasenregelkreises 2 die Glättung des Oszillatoreingangssignales u_{CO} wesentlich zu verbessern oder bei gleichwertiger Glättung wesentlich die Dynamik zu erhöhen. D.h., die entgegengesetzte Kopplung von Dynamik und Glättung bei Phasenregelkreisen ist durch das erfindungsgemäße Verfahren aufgebrochen, wodurch nun Dynamik und Glättung voneinander getrennt eingestellt werden können.

## Patentansprüche

1. Verfahren zur Minimierung eines Wechselanteils eines Phasendetektorausgangssignals (u_{PD}) eines Phasenregelkreises (2), bestehend aus einer Reihenschaltung eines Phasendetektors (4), eines Reglers (6) und eines gesteuerten Oszillators (8), der durch einen Teiler (10) auf den Phasendetektor (4) rückgekoppelt ist, wobei zu dieser Rückkopplung parallel eine zweite Rückkopplung existiert, in der mittels eines Korrektursignalbildners (18) für ein Oszillatorausgangssignal (u₃) ein Phasendetektorausgangssignal (u_{PD}) des eingerasteten Phasenregelkreises (2) als Korrektursignal (u_{Korr}) nachgebildet wird, das in Phasenlage und Frequenz fest auf die Grundschwingung des eingerasteten Phasenregelkreises (2) bezogen ist und das fortlaufend vom anstehenden Phasendetektorausgangssignal (u_{PD}) subtrahiert wird.

2. Verfahren zur Minimierung eines Wechselanteils eines Phasendetektorausgangssignals (u_{PD}) eines Phasenregelkreises (2), bestehend aus einer Reihenschaltung eines Phasendetektors (4), eines Reglers (6) und eines gesteuerten Oszillators (8), der durch einen Teiler (10) auf den Phasendetektor (4) rückgekoppelt ist, wobei zu dieser Rückkopplung eine zweite Rückkopplung existiert, in der mittels eines Korrektursignalbildners (18) für ein Oszillatorausgangssignal (u₃) ein Eingangssignal (u₁) des eingerasteten Phasenregelkreises (2) als Korrektursignal (u_{Korr'}) nachgebildet wird, das in Phasenlage und Frequenz fest auf die Grundschwingung des eingerasteten Phasenregelkreises (2) bezogen ist und das fortlaufend vom Eingangssignal (u₁) des Phasenregelkreises (2) subtrahiert wird.

3. Verfahren nach Anspruch 1 oder 2, wobei das erzeugte Korrektursignal (u_{Korr'}, u_{Korr'}) derart bearbeitet wird, daß sein zeitlicher Mittelwert den Wert Null annimmt.

4. Verfahren nach Anspruch 1 oder 2, wobei die Amplitude des erzeugten Korrektursignals (u_{Korr}, u_{Korr'}) auf die Amplitude des Eingangssignals (u₁) normiert wird.

5. Schaltungsanordnung zur Durchführung des Verfahrens nach Anspruch 1 mit einem Phasenrege_kreis (2), bestehend aus einer Reihenschaltung eines Phasendetektors (4), eines Reglers (6) und eines durch einen Teiler (10) auf den Phasendetektor (4) rückgekoppelten spannungsgesteuerten Oszillators (8), wobei dem Phasendetektor (4) ein Vergleicher (22) nachgeschaltet ist, der ausgangsseitig mit dem Regler (6) verknüpft ist, und wobei ein Korrektursignalbildner (18) in einer zweiten Rückkopplung eingangsseitig mit dem Ausgang des spannungsgesteuerten Oszillators (8) und ausgangsseitig mit dem negativen Eingang des Vergleichers (22) verbunden ist, wobei mittels eines Oszillatorausgangssignal (u₃) ein Phasendetektorausgangssignal (u_{pd}) des ein gerasteten Phasenregeltreises (2) als Korrektursignal (uₖₒᵣᵣ) nachgebildet wird, das in Phasentage und Frequenz fest auf die Grundschwingung des eingerasteten Phasenregelkreises (2) bezogen ist und das fortlanfend vom anstehenden Phasendetektorausgangssignal (u_{pd}) subtrahiert wird.

6. Schaltungsanordnung zur Durchführung des Verfahrens nach Anspruch 2 mit einem Phasenregelkreis (2), bestehend aus einer Reihenschaltung Phasendetektors (4), eines Reglers (6) und eines durch einen Teiler (10) auf den Phasendetektor (4) rückgekoppelten spannungsgesteuerten Oszillators (8), wobei dem Phasendetektor (4) ein Vergleicher (22) vorgeschaltet ist, an dessen positiven Eingang ein Eingangssignal (u₁) ansteht, und wobei ein Korrektursignalbildner(18), in einer Rückkopplung eingangsseitig mit dem Ausgang des spannungsgesteuerten Oszillators (8) und ausgangsseitig mit dem negativen Eingang des Vergleichers (22) verbunden ist, wobei mittels eines Oszillatorausgangssignals ein Eingangssignal (u₁) des eingerasteten Phasenregelkreises (2) als Korrektursignal (uₖₒᵣᵣ) nachgebildet wird, das in Phasenlage und Frequenz fest auf die Grundschwingung des eingerasteten Phasenregelkreises (2) bezogen ist und fortlaufend vom Eingangssignal (u₁) des Phasenregelkreises (2) subtrahiert wird.

7. Schaltungsanordnung nach Anspruch 5 oder 6, wobei dem Korrektursignalbildner (18) ein Gleichanteilfilter (20) nachgeschaltet ist.

8. Schaltungsanordnung nach Anspruch 5 oder 6, wobei dem Korrektursignalbildner (18) die Amplitude des Eingangssignals (u₁) zugeführt ist.

9. Schaltungsanordnung nach Anspruch 5 oder 6, wobei als Korrektursignalbildner (18) eine Reihenschaltung eines Zählers (23), eines Speichers (24) und eines Digital-Analog-Wandlers (26) vorgesehen ist.

10. Schaltungsanordnung nach Anspruch 5 oder 6, wobei als Korrektursignalbildner (18) ein Funktionsgenerator vorgesehen ist.

11. Schaltungsanordnung nach Anspruch 9, wobei als Digital-Analog-Wandler (26) ein multiplizierender Digital-Analog-Wandler vorgesehen ist.

12. Schaltungsanordnung nach Anspruch 7, wobei als Gleichanteilfilter (20) ein Regelkreis vorgesehen ist, der aus einem Vergleicher (28) und einem integral wirkenden Regler (30) besteht, wobei der Vergleicher (28) ausgangsseitig über den integral wirkenden Regler (30) auf seinen negativen Eingang rückgekoppelt ist.

## Claims

1. Process to minimize an alternating component of a phase detector output signal (u_{PD}) of a phase-locked loop (2), consisting of a series circuit of a phase detector (4), a controller (6) and a controlled oscillator (8), which is fed back to the phase detector (4) by a divider (10), whereby a second feedback exists parallel to this feedback, in which second feedback by means of a correction-signal former (18) for an oscillator output signal (u₃) a phase detector output signal (u_{PD}) of the locked phase-locked loop (2) is simulated as correction signal (uₖₒᵣᵣ), which in phase angle and frequency is firmly related to the fundamental oscillation of the locked phase-locked loop (2) and which is continuously subtracted from the applied phase detector output signal (u_{PD}).

2. Process to minimize an alternating component of a phase detector output signal (u_{PD}) of a phase-locked loop (2), consisting of a series circuit of a phase detector (4), a controller (6) and a controlled oscillator (8) which is fed back to the phase detector (4) by a divider (10), whereby a second feedback exists parallel to this feedback, in which second feedback by means of a correction-signal former (18) for an oscillator output signal (u₃) an input signal (u₁) of the locked phase-locked loop (2) is simulated as correction signal (uₖₒᵣᵣ,), which in phase angle and frequency is firmly related to the fundamental oscillation of the locked phase-locked loop (2) and which is continuously subtracted from the input signal (u₁) of the phase-locked loop (2).

3. Process according to claim 1 or 2, whereby the generated correction signal (uₖₒᵣᵣ, u_{korr'}) is processed in such a way that its temporal mean value assumes the value zero.

4. Process according to claim 1 or 2, whereby the amplitude of the generated correction signal (uₖₒᵣᵣ, u_{korr'}) is standardized to the amplitude of the input signal (u₁).

5. Circuit arrangement for carrying out the process according to claim 1, having a phase-locked loop (2), consisting of a series circuit of a phase detector (4), a controller (6) and a voltage-controlled oscillator (8) fed back to the phase detector (4) by a divider (10), whereby a comparator (22) is connected downstream of the phase detector (4), which comparator is connected on the output side to the controller (6), and whereby a correction-signal former (18) in a second feedback is connected on the input side to the output of the voltage-controlled oscillator (8) and on the output side to the negative input of the comparator (22), whereby by means of an oscillator output signal (u₃) a phase detector output signal (u_{pd}) of the locked phase-locked loop (2) is simulated as correction signal (uₖₒᵣᵣ) which in phase angle and frequency is firmly related to the fundamental oscillation of the locked phase-locked loop (2) and which is continuously subtracted from the applied phase detector output signal (u_{pd}).

6. Circuit arrangement for carrying out the process according to claim 2 with a phase-locked loop (2), consisting of a series circuit of a phase detector (4), a controller (6) and a voltage-controlled oscillator (8) fed back to the phase detector (4) by a divider (10), whereby a comparator (22) is connected upstream of the phase detector (4), to the positive input of which comparator an input signal (u₁) is applied, and whereby a correction-signal former (18) in a feedback is connected on the input side to the output of the voltage-controlled oscillator (8) and on the output side to the negative input of the comparator (22), whereby by means of an oscillator output signal an input signal (u₁) of the locked phase-locked loop (2) is simulated as correction signal (uₖₒᵣᵣ), which in phase angle and frequency is firmly related to the fundamental oscillation of the locked phase-locked loop (2) and is continuously subtracted from the input signal (u₁) of the phase-locked loop (2).

7. Circuit arrangement according to claim 5 or 6, whereby a direct-component filter (20) is connected downstream of the correction-signal former (18).

8. Circuit arrangement according to claim 5 or 6, whereby the amplitude of the input signal (u₁) is supplied to the correction-signal former (18).

9. Circuit arrangement according to claim 5 or 6, whereby as correction-signal former (18) a series circuit of a counter (23), a memory (24) and a digital-to-analog converter (26) is provided.

10. Circuit arrangement according to claim 5 or 6, whereby a function generator is provided as correction-signal former (18).

11. Circuit arrangement according to claim 9, whereby a multiplying digital-to-analog converter is provided as digital-to-analog converter (26).

12. Circuit arrangement according to claim 7, whereby as direct-component filter (20) a control loop is provided which consists of a comparator (28) and an integrally acting controller (30), whereby the comparator (28) is fed back on the output side to its negative input by way of the integrally acting controller (30).

## Revendications

1. Procédé de minimisation d'une composante alternative d'un signal (u_{PD}) de sortie d'un détecteur de phase d'une boucle (2) à verrouillage de phase, constituée d'un circuit série d'un détecteur (4) de phase, d'un régulateur (6) et d'un oscillateur (8) commandé, qui est en rétroaction avec le détecteur (4) de phase par un diviseur (10), dans lequel il existe, en parallèle avec cette rétroaction, une seconde rétroaction dans laquelle on reproduit au moyen d'un dispositif (18) de formation d'un signal de correction pour un signal (u₃) de sortie de l'oscillateur un signal (u_{PD}) de sortie du détecteur de phase de la boucle (2) à verrouillage de phase verrouillée en tant que signal (uₖₒᵣᵣ) de correction, le signal de correction étant rapporté de manière fixe en phase et en fréquence à l'oscillation fondamentale de la boucle (2) à verrouillage de phase verrouillée et étant soustrait en continu du signal (u_{PD}) de sortie disponible du détecteur de phase.

2. Procédé de minimisation d'une composante alternative d'un signal (u_{PD}) de sortie d'un détecteur de phase d'une boucle (2) à verrouillage de phase, constituée d'un circuit série d'un détecteur (4) de phase, d'un régulateur (6) et d'un oscillateur (8) commandé, qui est en rétroaction avec le détecteur (4) de phase par un diviseur (10), dans lequel il existe, en parallèle avec cette rétroaction,une seconde rétroaction, dans laquelle on reproduit au moyen d'un dispositif (18) de formation d'un signal de correction pour un signal (u₃) de sortie de l'oscillateur un signal (u₁) d'entrée de la boucle (2) à verrouillage de phase verrouillée en tant que signal (uₖₒᵣᵣ,) de correction, le signal de correction étant rapporté de manière fixe en phase et en fréquence à l'oscillation fondamentale de la boucle (2) à verrouillage de phase verrouillée et étant soustrait en continu du signal (u₁) d'entrée de la boucle (2) à verrouillage de phase.

3. Procédé suivant la revendication 1 ou 2, dans lequel on traite le signal (uₖₒᵣᵣ, u_{korr'},) de correction produit de telle sorte que sa valeur moyenne dans le temps prenne la valeur zéro.

4. Procédé suivant la revendication 1 ou 2, dans lequel on norme l'amplitude du signal (uₖₒᵣᵣ, u_{korr'}) de correction produit à l'amplitude du signal (u₁) d'entrée.

5. Montage pour la mise en oeuvre du procédé suivant la revendication 1, comportant une boucle (2) à verrouillage de phase, constituée d'un circuit série alun détecteur (4) de phase, d'un régulateur (6) et d'un oscillateur (8) commandé par tension et en rétroaction avec le détecteur (4) de phase par un diviseur (10), un comparateur (22), qui est relié en sortie au régulateur (6), étant branché en aval du détecteur (4) de phase, un dispositif (18) de formation d'un signal de correction étant relié, dans une seconde rétroaction, en entrée à la sortie de l'oscillateur (8) commandé par tension, et en sortie à l'entrée négative du comparateur (22), un signal (u_{PD}) de sortie du détecteur de phase de la boucle (2) à verrouillage de phase verrouillée étant reproduit, au moyen d'un signal (u₃) de sortie de l'oscillateur, en tant que signal (uₖₒᵣᵣ) de correction, qui est rapporté de manière fixe en phase et en fréquence à l'oscillation fondamentale de la boucle (2) à verrouillage de phase verrouillée et qui est soustrait en continu du signal (u_{PD}) de sortie disponible du détecteur de phase.

6. Montage pour la mise en oeuvre du procédé suivant la revendication 2, comportant une boucle (2) à verrouillage de phase, constituée d'un circuit série d'un détecteur (4) de phase, d'un régulateur (6) et d'un oscillateur (8) commandé par tension et en rétroaction avec le détecteur (4) de phase par un diviseur (10), un comparateur (22), à l'entrée positive duquel est appliqué un signal (u₁) d'entrée, étant branché en amont du détecteur (4) de phase, et un dispositif (18) de formation de signal de correction étant relié, dans une rétroaction, en entrée à la sortie de l'oscillateur (8) commandé par tension et en sortie à l'entrée négative du comparateur (22), un signal (u₁) d'entrée de la boucle (2) à verrouillage de phase verrouillée étant reproduit, au moyen d'un signal de sortie de l'oscillateur, en tant que signal (uₖₒᵣᵣ) de correction, qui est rapporté de manière fixe en phase et en fréquence à l'oscillation fondamentale de la boucle (2) à verrouillage de phase verrouillée et qui est soustrait en continu du signal (u₁) d'entrée de la boucle (2) à verrouillage de phase.

7. Montage suivant la revendication 5 ou 6, dans lequel il est branché en aval du dispositif (18) de formation d'un signal de correction un filtre (20) de composante continue.

8. Montage suivant la revendication 5 ou 6, dans lequel il est envoyé au dispositif (18) de formaticn de signal de correction l'amplitude du signal (u₁) d'entrée.

9. Montage suivant la revendication 5 ou 6, dans lequel il est prévu comme dispositif (18) de formation d'un signal de correction un circuit série d'un compteur (23), d'une mémoire (24) et d'un convertisseur (26) numérique-analogique.

10. Montage suivant la revendication 5 ou 6, dans lequel il est prévu comme dispositif (18) de formation d'un signal de correction un générateur de fonction.

11. Montage suivant la revendication 9, dans lequel il est prévu comme convertisseur numérique-analogique (26) un convertisseur numérique-analogique multiplicateur.

12. Montage suivant la revendication 7, dans lequel il est prévu comme filtre (20) de composante continue une boucle à verrouillage, qui est constituée d'un comparateur (28) et d'un régulateur (30) à action intégrale, le comparateur (28) étant en rétroaction en sortie par l'intermédiaire du régulateur (30) à action intégrale avec son entrée négative.
